# EUROPÄISCHE PATENTSCHRIFT

(11) **EP 1 520 457 B1**
(45) Veröffentlichungstag und Bekanntmachung des Hinweises auf die Patenterteilung: **03.05.2006**
(21) Anmeldenummer: 03718802.6
(22) Anmeldetag: 16.05.2003
(51) Int. Cl.: H05K 9/00

(54) **ABSCHIRMEINRICHTUNG FÜR ELEKTRONISCHE BAUGRUPPEN AUF EINER LEITERPLATTE**
SCREENING DEVICE FOR ELECTRONIC SUBSASSEMBLIES ON A PRINTED CIRCUIT BOARD
DISPOSITIF DE BLINDAGE POUR DES MODULES ELECTRONIQUES MONTES SUR UNE CARTE DE CIRCUIT

(30) Priorität: 10.07.2002 DE 10231145
(43) Veröffentlichungstag der Anmeldung: 06.04.2005
(73) Patentinhaber: SIEMENS AKTIENGESELLSCHAFT, 80333 München (DE)
(72) Erfinder: FÜRSICH, Walter, 44149 Dortmund (DE)
(74) Vertreter: Berg, Peter
(86) Internationale Anmeldenummer: PCT/EP2003/005182
(87) Internationale Veröffentlichungsnummer: WO 2004/008823

(56) Entgegenhaltungen:
- EP-A- 1 061 789
- WO-A-01/10182
- US-A- 5 717 577
- US-B1- 6 239 359

## Beschreibung

### Bezeichnung der Erfindung

Die Erfindung betrifft eine Abschirmeinrichtung mit einer Abschirmkappe, die eine auf einer Leiterplatte angeordnete elektronische Schaltung abdeckt, mit einem Rand, der von einer Bestückungsseite der Leiterplatte durch einen Spalt beabstandet ist, mit einer Kontakteinrichtung, die im Spalt angeordnet ist und eine elektrische Verbindung zwischen der Abschirmkappe und einer leitenden Kontur auf der Leiterplatte herstellt, wobei am Rand der Abschirmkappe Laschen angeformt sind, durch die die Abschirmkappe auf der Leiterplatte festgelegt und die Kontakteinrichtung unter elastischer Vorspannung gehalten ist.

### Stand der Technik

In der Elektrotechnik ist es häufig erforderlich, elektrische oder magnetische Felder innerhalb oder außerhalb eines bestimmten Gebiets zu schwächen. Als Entstörmittel werden Schirmgehäuse verwendet, die die Abstrahlung oder die Einstrahlung von elektromagnetischer Störstrahlung dämpfen. Auf Leiterplatten kann die störende Einstrahlung auch von Baugruppen verursacht werden, die sich selbst auf der Leiterplatte befinden. Bei miniaturisierten Baugruppen, wie beispielsweise Baugruppen, die in SMD-Technik aufgebaut sind, liegen Störsenke und Störquelle oft in unmittelbarer Nachbarschaft. Zur Abschirmung zeitlich veränderlicher Feldgrößen werden mehrteilige Schirmungen in Kleinbauweise eingesetzt.

Sie bestehen meist aus einem Schirmrahmen, der durch Zwischenwände in einzelne Kammern unterteilt ist und mit der Leiterplatte verlötet ist. Um die von der Abschirmung abgedeckten elektronischen Bauelemente für Testzwecke zugänglich zu halten, ist der Schirmrahmen durch ein abnehmbares Deckelteil verschlossen. Da das Rahmenteil erst durch das Einlöten auf der Leiterplatte seine mechanische Stabilität erhält, ist es erforderlich, bei der Montage dieser miniaturisierten Schirmungen das Rahmenteil und das Deckelteil zusammen zu handhaben. Das Zusammenfügen und Abnehmen des Deckels sind umständlich und die Montage ist zeitaufwendig.

Eine einteilige, metallische Schirmung, die auf eine Leiterplatte aufsteckbar ist, ist aus DE 29 808 620 U1 bekannt. Die Befestigung erfolgt durch Rasthaken, welche die Leiterplatte rückseitig hintergreifen. Die Massekontaktierung des Schirms mit der Leiterplatte wird durch eine Vielzahl federnder Lappen gebildet. Diese Lappen stehen bei einer montierten Abschirmwanne unter elastischer Vorspannung und stellen den elektrischen Kontakt durch eine Linien- bzw. Punktberührung her. Unter rauen Betriebsbedingungen kann es vorkommen, dass Abschnitte der Kontaktierung durch mechanische Einwirkungen oder durch Korrosion versagen. In diesem Fall ist die Abschirmeffizienz des Entstörmittels beeinträchtigt. Ein weiterer Nachteil ist, dass bei der Montage der Abschirmung zur Überwindung der Federkraft der einzelnen Lappen eine Anpresskraft erforderlich ist, die auf die Abschirmwanne aufgebracht und von der Leiterplatte aufgenommen werden muss. Die Abschirmwirkung hängt aber von der kontaktierenden Federkraft und dem Abstand der einzelnen Kontaktpunkte ab. Wenn aber eine Vielzahl federnder Lappen elastisch verformt werden muss, ist ein entsprechend hoher Anpressdruck erforderlich und es kann bei miniaturisierten Baugruppen vorkommen, dass die Leiterplatte unzulässig verformt wird. An der Leiterstruktur können sich Mikrorisse ausbilden.
Auch bei der aus der DE 297 13 412 U1 bekannten Schirmung wird die Kontaktierung durch am Schirmrand umlaufende Kontaktfedern hergestellt.

Die Herstellung dieser bekannten, einteiligen Schirmungen erfordert ein komplexes Fertigungswerkzeug. Änderungen an diesem Werkzeug, die für die Herstellung einer neuen Abschirmgeometrie oder Raumform erforderlich sind, sind nur mit vergleichsweise hohem Aufwand möglich.

### Darstellung der Erfindung

Der Erfindung liegt die Aufgabe zu Grunde, eine Abschirmeinrichtung der eingangs genannten Art derart weiter zu entwickeln, dass die Abschirmeffizienz verbessert wird und die Herstellung, insbesondere die Herstellung unterschiedlich großer Abschirmeinrichtungen, die nur partielle Bereiche auf der Leiterplatte schirmen, mit geringerem Aufwand möglich ist.

Diese Aufgabe wird erfindungsgemäß bei einer Abschirmeinrichtung der eingangs genannten Art mit den kennzeichnenden Merkmalen von Anspruch 1 gelöst. Auf vorteilhafte Ausgestaltungen nehmen die Unteransprüche Bezug.

Bei der erfindungsgemäßen Abschirmeinrichtung ist vorgesehen, dass die Kontakteinrichtung durch einen im Spalt umlaufend angeordneten Dichtkörper gebildet wird, wobei der Dichtkörper aus einem elastischen, elektromagnetische Wellen absorbierenden Werkstoff hergestellt ist. Charakteristisch für die Erfindung ist also mithin, dass die kontaktierung nicht, durch eine Vielzahl von Kontaktpunkten mit Linien- oder Punktberührung erfolgt, sondern durch einen flächig anliegenden Dichtkörper aus einem elastischen Material. Dieser passt sich auf Grund seiner Kompressionsfähigkeit besser an Wölbungen und Unebenheiten der Leiterplatte an. Auch bei mechanischen Stößen oder Vibrationen bleibt ein niedriger ohmscher Übergangswiderstand der Massekontaktierung erhalten. Außerdem liegt der in der Fuge umlaufende Dichtkörper zwischen Schirmgehäuse und Leiterplatte dichtend an und bildet auf diese Weise zusätzlich einen Schutz vor in den Innenraum der Abschirmung eindringender Verschmutzung.

Durch die konstruktive Loslösung der Kontaktierung vom Schirmrahmen vereinfacht sich dessen Herstellung. Das Herstellungswerkzeug der Abschirmkappe ist einfacher aufgebaut. Rüstkosten für Änderungen am Fertigungswerkzeug sind niedriger. Die Abschirmkappe kann kostengünstig in Großserie als Stanz-Biegeteil aus Blech hergestellt werden. Der Dichtkörper kann ein Zuschnitt oder ein Halbzeug sein. Insgesamt kann eine Anpassung der Fertigung auf eine partielle Abschirmung unterschiedlich großer Bereiche auf einer Leiterplatte mit geringerem Aufwand realisiert werden.

Überraschenderweise hat sich herausgestellt, dass eine bereits nur wenige Millimeter breite EMV-Dichtung eine sehr gute Abschirmeffizienz gegenüber HF-Feldern ermöglicht.

Werkstoffe, die hinsichtlich elektromagnetischer Strahlung eine aufzehrende Wirkung aufweisen, sind in verschiedenen Zusammensetzungen und Ausführungen bekannt und handelsüblich.

Für eine einfache Befestigung der Abschirmkappe auf der Leiterplatte ist vorgesehen, dass die Leiterplatte mit Durchtrittsöffnungen versehen ist und ein austrittseitig aus der Durchtrittsöffnung hervorstehendes Ende einer Lasche plastisch so verformt wird, dass es die Leiterplatte rückseitig hintergreift. Dadurch entsteht eine einfach herzustellende formschlüssige Verbindung. Das plastische Verformen der vorstehenden Endabschnitte kann durch Biegen, Prägen oder Stauchen erfolgen. Um für Testzwecke ein einfaches Abnehmen der Kappe zu ermöglichen, kann jedes Endstück einer Lasche als Schränklappen ausgebildet sein.

Hinsichtlich der Fertigungskosten ist es günstig, wenn die Abschirmkappe materialeinheitlich und einstückig ineinander übergehend aus einem metallischen Werkstoff, beispielsweise aus Weißblech, gebildet ist. Das Weißblech kann durch Verzinnen geschützt sein.

In einer weiteren Ausgestaltung der Erfindung ist vorgesehen, dass der Rand als rechtwinkelige Abkantung ausgebildet ist, die im montierten Zustand der Abschirmkappe im wesentlichen parallel zur Bestückungsseite verläuft und jede Lasche außenumfangsseitig angeformt und im Verlauf von einer Wand der Abschirmkappe abgesetzt ausgeführt ist. Dadurch kann die Abschirmkappe in einem Stanz- und Biegevorgang hergestellt werden.
Bei diesem Stanz-Biegeteil kann eine sehr wirkungsvolle Abschirmung dadurch realisiert werden, indem der Dichtkörper als Flachdichtung ausgebildet ist und durch einen elektrisch leitfähigen Klebstoff am Rand der Abschirmkappe oder der Bestückungsseite der Leiterplatte befestigt ist. Darüber hinaus ergibt sich der Vorteil, dass bei der Montage die Abschirmkappe samt Dichtung als ein Teil handhabbar ist.

Zur Verbesserung der Kontaktsicherheit weist die leitende Kontur der Leiterplatte kuppenförmige Kontaktpunkt auf, die sich in die Flachdichtung eindrücken. Ihre Oberfläche ist durch die elastische Flachdichtung dichtend abgeschlossen und gegen Korrosion weitgehend geschützt.

Wenn nur partielle Bereiche auf einer Leiterplatte geschirmt werden müssen, kann es günstig sein, wenn die Abschirmkappe hinsichtlich der abzuschirmenden Geometrie im Rastermaß der Leiterplatte quaderförmiger ausgebildet ist. Diese einheitlich modulare Bauweise senkt Herstellungs- und Logistikkosten.

Für den Fall, dass der Innenraum der Abschirmung belüftet bzw. entlüftet werden muss, ist vorgesehen, dass die Abschirmkappe an einem Deckenteil und/oder an einem Wandteil mit Durchbrüchen versehen ist, die Durchtrittsöffnung für Kühlluft bilden. Die Größe der Durchbrüche ist an das abzuschirmende Frequenzspektrum angepasst.

Wenn auf der Leiterplatte partielle Gebiete unterschiedliche Schirmwirkungen erfordern, ist vorgesehen, dass auf einer Leiterplatte mehrere Abschirmkappen angeordnet sind und die Schirmeffizienz dieser Abschirmkappen unterschiedlich ist.

Zur weiteren Kostensenkung können handelsübliche EMV-Materialien verwendet werden, das sind polymere Werkstoffe, besonders bevorzugt Polyamid-Vlies, das metallisch beschichtet oder durch ein Metallgeflecht umstrickt ist.

### Kurzbeschreibung der Zeichnungen

Die Erfindung wird nachfolgend an Hand eines in den Zeichnungen dargestellten Ausführungsbeispiels näher beschrieben. Es zeigen:
- Figur 1: eine perspektivische Explosionsdarstellung der erfindungsgemäßen Abschirmeinrichtung, in einer Ausführung, bei der die gesamte Leiterplatte von der Abschirmkappe abgedeckt ist,
- Figur 2: eine vergrößerte Detaildarstellung der Abschirmkappe von der Unterseite,
- Figur 3: eine Detaildarstellung eines Randbereichs einer auf einer Leiterplatte montierten Abschirmeinrichtung in quergeschnittener Darstellung,
- Figur 4: einen Abschnitt der leitenden Kontur auf der Leiterplatte mit auf Lücke versetzt angeordneten Kontaktpunkten.

### Ausführung der Erfindung

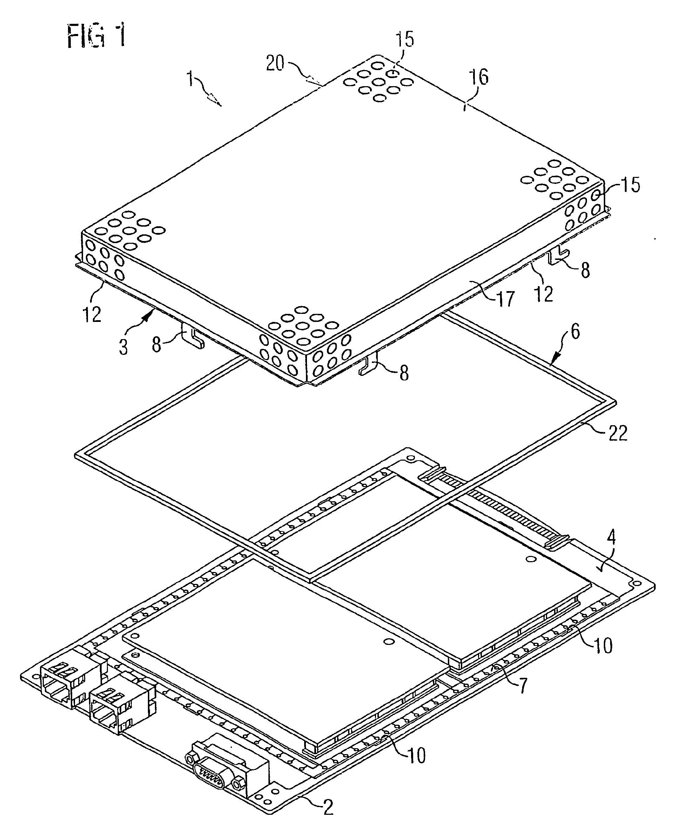

In der Zeichnung ist in Figur 1 beispielhaft eine Ausführungsform der erfindungsgemäßen Abschirmeinrichtung 1 in einer perspektivischen Explosionsdarstellung wiedergegeben. Die Abschirmeinrichtung 1 besteht aus einer Abschirmkappe 20 und aus einer Kontakteinrichtung 6. Die Abschirmkappe 20 deckt im gezeigten Beispiel den gesamten Bereich der Leiterplatte 2 ab. Die folgenden Erläuterungen sind jedoch nicht eingeschränkt auf diese Ausführungsform beschränkt, sondern erfassen insbesondere auch Abschirmeinrichtungen die nur partielle Bereiche auf der Leiterplatte abschirmen.

Wie die Figur 1 zeigt, sind am Rand 3 der Abschirmkappe 20 außenumfangsseitig Laschen 8 angeformt, durch welche die Abschirmkappe 20 auf einer Bestückungsseite 4 der Leiterplatte 2 festlegbar ist. Auf der Bestückungsseite 4 der Leiterplatte 2 ist eine leitende Kontur 7 zu sehen, deren Umriss mit dem Randbereich der Abschirmkappe 20 korrespondiert. Die leitende Kontur 7 besteht aus Kontaktpunkten, die untenstehend näher erläutert sind, und ist in Ätztechnik im Rastermaß hergestellt. Die Kontakteinrichtung 6 ist als umlaufende Dichtung 22 ausgebildet. Bei der Montage der Abschirmeinrichtung wird die Abschirmkappe 20 auf die Leiterplatte 2 abgesenkt. Beim Absenken tauchen die in Richtung Leiterplatte 2 weisenden Laschen 8 in Durchtrittsöffnungen 10 der Leiterplatte 2. Im weiteren Verlauf des Absenken kommt es zunächst zu einer Pressung des elastischen Dichtkörpers 22. Die Pressung erfordert wegen der guten Kompressionseigenschaften des Dichtungswerkstoffs nur eine geringe Anpresskraft. Ein weiteres Absenken bewirkt, dass jedes Endstück 9 der Lasche 8 die Durchtrittsöffnung passiert und rückseitig übersteht. Zwecks Befestigung der Abschirmkappe wird nun der austrittseitig aus der Durchtrittsöffnung überstehende Schränklappen durch eine wechselseitige Biegung plastisch verformt. Es entsteht zwischen Kappe 20 und Träger 2 eine formschlüssige Verbindung. Wie bereits dargestellt kann die plastische Verformung aber auch durch Umbiegen, durch Prägen, oder durch Stauchen erfolgen. Im Spalt zwischen Kappenrand und Bestückungsseite wird der elastische Dichtkörper 22 zusammengepresst. In den Dichtspalt 5 eindringende elektromagnetische Strahlungsenergie wird beim Durchgang auf Grund der dämpfenden Materialeigenschaften des Dichtungswerkstoffs stark abgeschwächt. Die Montage erfordert wegen des leichten Komprimierens des Dichtungswerkstoffs nur eine vergleichsweise geringe Anpresskraft. In Figur 1 ist die Abschirmhaube in ihre Längsseite mit zwei, in ihrer Breitseite mit einem angeformten Befestigungslappen gezeigt. Selbstverständlich variiert die Anzahl der Befestigungslappen entsprechend der Größe der Abschirmkappe. Die Durchtrittsöffnungen 15 für die Be- bzw. Entlüftung des Innenraums sind stark vergrößert gezeichnet. In Wirklichkeit ist der Durchmesser dieser Bohrungen sehr klein und auf die abzuschirmende Frequenz des Wechselfeldes abgestimmt. Die Abschirmkappe 20 ist ein einteiliges Biege-Stanzteil aus einem verzinnten Weißblech.

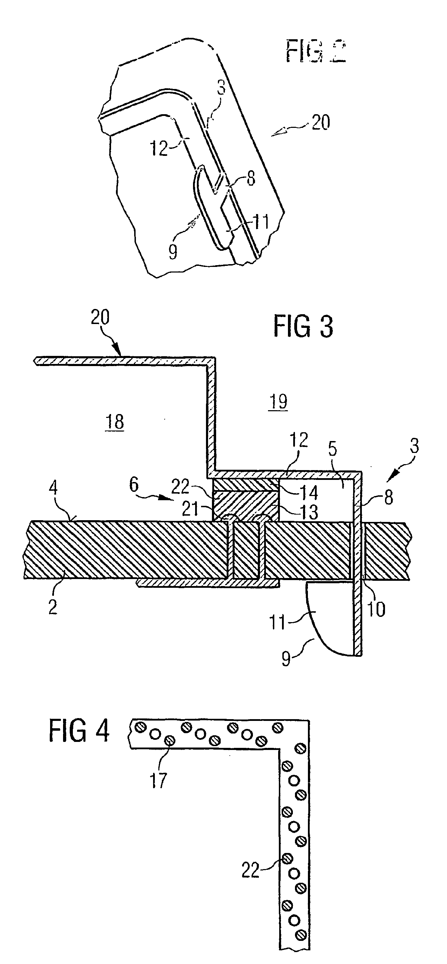

In den Figuren 2 und 3 ist der Randbereich der Abschirmkappe in einer vergrößerten Detaildarstellung gezeichnet. Der Rand 3 der Abschirmkappe 20 ist durch eine rechtwinkelige Abkantung 12 fortgesetzt. Außenumfangsseitig ist die Lasche 8 an der Abkantung 12 angeformt. Der Endabschnitt 9 der Lasche 8 ist als Schränklappen 11 ausgeführt. Wie aus der quergeschnittenen Darstellung der Figur 3 leicht zu entnehmen ist, ist die Lasche 8 durch die Durchtrittsöffnung 10 der Leiterplatte 2 durchgesteckt. Der Endabschnitt 9 ist durch wechselseitiges Biegen um eine in Durchtrittsrichtung weisende Achse plastisch verformt. Dadurch hintergreift der Schränklappen 11 die Rückseite der Leiterplatte 2. Bei geschlossener Ausführungsform der Abschirmkappe schützt die umlaufende Dichtung 22 gleichzeitig auch den Innenraum 18 vor aus dem Außenraum 19 eindringenden Staub oder vor Verschmutzung. In der Schnittdarstellung der Figur 3 ist die Dichtung 22 als Flachdichtung 13 gezeichnet. Sie steht im Dichtspalt 5 zwischen Leiterplatte 2 und Rand 12 unter elastischer Vorspannung. Die Flachdichtung 13 ist an einer Oberseite mit einem Klebstoff 14 beschichtet, wodurch Dichtung und Abschirmkappe bei der Montage eine Einheit bilden und leichter handhabbar sind. Die Unterseite der Flachdichtung 13 liegt längs der leitenden Kontur 7 auf der Bestückungsseite 4. Die leitende Kontur 7 wird durch kuppenförmige Kontaktpunkte 21 gebildet, die über ein entsprechendes Layout elektrisch angebunden sind. Durch die Pressung im Dichtspalt 5 kommt es zu einer elastischen Verformung des Dichtungswerkstoffs. Die Kontaktpunkte 21 pressen sich an der Unterseite der Flachdichtung ein. Durch diese Umhüllung der Kuppenoberfläche ist die Kontaktstelle vor äußeren Einwirkungen sehr gut geschützt. Einer Korrosion im Kontaktierungsbereich wird dadurch entgegengewirkt. Folge davon ist, dass über eine sehr lange Gebrauchsdauer der ohmsche Übergangswiderstand der Massekontaktierung gleich niedrig gehalten werden kann. Die Kontur 7 kann auch durch eine durchgehende Leiterbahn oder durch ein anderes Kontakt-Muster gebildet sein. Selbstverständlich ist es auch möglich, die Flachdichtung 13 auch von der unteren Seite her mit einem leitfähigen Klebstoff zu beschichten.

Die Anordnung der kuppenförmigen Kontaktpunkte 21 längs der leitenden Kontur 7 ist in Figur 4 in einer Aufsicht vergrößert dargestellt. Die Kontaktpunkte 21 sind auf Lücke versetzt angeordnet. Der Abstand der Kontaktpunkte in Längserstreckung der Massekontaktierung gesehen beträgt im Beispiel vier Millimeter. Die Kuppen an den Kontaktpunkten sind verzinnt und haben einen Durchmesser von 1,3 Millimeter. Die EMV-Flachdichtung besteht aus einem Polyamid-Spunbond-Vlies, das eine hohe Kompressionsfähigkeit von bis zu 85 Prozent aufweist und sehr flexibel ist.

Die EMV-Dichtung kann aber auch anders aufgebaut sein und aus anderen Werkstoffen bestehen. Die Dichtung kann beispielsweise ein offenzelliger Schaumstoff sein, dem elektrisch und magnetisch leitfähige Partikel zugesetzt sind. Geeignet sind ferner auch Vlies- und Verbundwerkstoffe, die Fasern aus einem Material mit dieser Leitfähigkeits-Eigenschaft enthalten.

Das Metallgeflecht kann ein verzinntes, kupferkaschiertes Stahldrahtgeflecht sein. Der Dichtkörper kann vom Stahlgeflecht umsponnen sein. Es ist aber auch möglich, dass das metallische Geflecht durch polymere Verfestigung im Dichtkörper eingebettet ist.

## Patentansprüche

1. Abschirmeinrichtung, die aufweist:
· eine Abschirmkappe (20), die eine auf einer Leiterplatte (2) angeordnete elektronische Schaltung abdeckt, mit einem Rand (3), der von einer Bestückungsseite (4) der Leiterplatte durch einen Spalt (5) beabstandet ist,
· eine Kontakteinrichtung (6), die im Spalt angeordnet ist und eine elektrische Verbindung: zwischen der Abschirmkappe und einer leitenden Kontur (7) auf der Leiterplatte herstellt, wobei am Rand der Abschinnkappe Laschen (8) angeformt sind, durch die die Abschirmkappe auf der Leiterplatte festgelegt und die Kontakteinrichtung unter elastischer Vorspannung gehalten ist, wobei die Kontakteinrichtung als ein im Spalt umlaufender, elastischer Dichtkörper (22) ausgebildet ist, der elektromagnetische Wellen absorbiert, **dadurch gekennzeichnet, dass** die leitende Kontur (7) durch kuppenförmige Kontaktpunkte (21) gebildet ist.

2. Abschirmeinrichtung nach Anspruch 1, **dadurch gekennzeichnet, dass** die kuppenförmige Kontaktpunkte (21) auf der Bestückungsseite (4) der Leiterplatte (2) im Rastermaß angeordnet sind.

3. Abschirmeinrichtung nach Anspruch 1 oder 2, **dadurch gekennzeichnet, dass** die Leiterplatte (2) mit Durchtrittsöffnungen (10) versehen ist, dass nach Festlegung der Abschirmkappe (20) die Laschen (8) austrittseitig aus der Durchtrittsöffnung hervorstehen und plastisch verformte Endabschnitte (9) der Laschen die Leiterplatte (2) rückseitig hintergreifen.

4. Abschirmeinrichtung nach Anspruch 3, **dadurch gekennzeichnet, dass** jedes Endstück einer Lasche (8) als Schränklappen (11) ausgebildet ist.

5. Abschirmeinrichtung nach zumindest einem der vorstehenden Ansprüche, **dadurch gekennzeichnet, dass** die Abschirmkappe (20) materialeinheitlich und einstückig ineinander übergehend aus einem metallischen Werkstoff gebildet ist.

6. Abschirmeinrichtung nach zumindest einem der vorstehenden Ansprüche, **dadurch gekennzeichnet, dass** der Rand.(3) als rechtwinkelige Abkantung (12) ausgebildet ist, die im montierten Zustand der Abschirmkappe (20) im wesentlichen parallel zur Bestückungsseite (4) verläuft, und jede Lasche (8) außenumfangsseitig angeformt und im Verlauf von einer Wand (17) der Abschirmkappe (20) abgesetzt ausgeführt ist.

7. Abschirmeinrichtung nach zumindest einem der vorstehenden Ansprüche, **dadurch gekennzeichnet, dass** der Dichtkörper (22) als Flachdichtung (13) ausgebildet ist und durch einen elektrisch leitfähigen Klebstoff (14) am Rand (3) der Abschirmkappe (20) oder der Bestückungsseite (4) befestigt ist.

8. Abschirmeinrichtung nach zumindest einem der vorstehenden Ansprüche, **dadurch gekennzeichnet, dass** die Abschirmkappe (20) als Stanz-Biegeteil ausgebildet ist.

9. Abschirmeinrichtung nach zumindest einem der vorstehenden Ansprüche, **dadurch gekennzeichnet dass** die Abschirmkappe (20) quaderförmig ausgebildet ist.

10. Abschirmeinrichtung nach zumindest einem der vorstehenden Ansprüche, **dadurch gekennzeichnet dass** an einem Deckenteil (16) und/oder an einem Wandteil (17) der Abschirmkappe (20) Durchbrüche (15) vorgesehen sind.

11. Abschirmeinrichtung nach zumindest einem der vorstehenden Ansprüche, **dadurch gekennzeichnet, dass** auf einer Leiterplatte (2) mehrere Abschirmkappen (20) angeordnet sind und die Schirmeffizienz dieser Abschirmkappen unterschiedlich ist.

12. Abschirmeinrichtung nach zumindest einem der vorstehenden Ansprüche, **dadurch gekennzeichnet, dass** der Dichtkörper (22) aus einem polymeren Werkstoff, besonders bevorzugt aus einem Polyamid-Vlies, das metallisch beschichtet oder durch ein Metallgeflecht umstrickt ist, gebildet ist.

13. Abschirmeinrichtung nach zumindest einem der vorstehenden Ansprüche, **dadurch gekennzeichnet, dass** der Dichtkörper (22) aus einem elektrisch leitfähigen Elastomer, das durch ein verzinntes, kupferkaschiertes Stahldrahtgeflecht umsponnen ist, gebildet ist.

## Revendications

1. Dispositif de blindage qui comprend :
- un capot (20) de blindage, qui recouvre un circuit électronique disposé sur une plaquette (2) à circuit imprimé, ayant un bord (3) qui est à distance par un intervalle (5) d'une face (4) d'implantation de la plaquette à circuit imprimé ;
- un dispositif (6) de contact, qui est disposé dans l'intervalle et qui ménage une liaison électrique entre le capot de blindage et un contour (7) conducteur sur la plaquette à circuit imprimé, des languettes (8) étant formées sur le bord du capot de blindage, languettes par lesquelles le capot de blindage peut être fixé sur la plaquette à circuit imprimé et le dispositif de contact maintenu sous précontrainte élastique, le dispositif de contact étant constitué en pièce (22) d'étanchéité élastique, faisant le tour dans l'intervalle et absorbant des ondes électromagnétiques, **caractérisé en ce que** le contour (7) conducteur est formé par des points (21) de contact en forme de dôme.

2. Dispositif de blindage suivant la revendication 1, **caractérisé en ce que** les points (21) de contact en forme de dôme sont disposés suivant une trame sur la face (4) d'implantation de la plaquette (2) à circuit imprimé.

3. Dispositif de blindage suivant la revendication 1 ou 2, **caractérisé en ce que** la plaquette (2) à circuit imprimé est munie d'ouvertures (10) traversantes, **en ce qu'**après la fixation du capot (20) de blindage, les languettes (8) font saillie du côté de la sortie de l'ouverture traversante et des tronçons (9) d'extrémité déformés plastiquement des languettes s'accrochent sur la face arrière de la plaquette (2) à circuit imprimé.

4. Dispositif de blindage suivant la revendication 3, **caractérisé en ce que** chaque tronçon d'extrémité d'une languette (8) est constitué sous la forme d'une patte (11) d'arrêt.

5. Dispositif de blindage suivant au l'une des revendications précédentes, **caractérisé en ce que** le capot (20) de blindage est en un matériau métallique unitaire du point de vue du matériau et d'une seule pièce.

6. Dispositif de blindage suivant au moins l'une des revendications précédentes, **caractérisé en ce que** le bord (3) est constitué sous la forme d'un chanfrein (12) à angle droit, qui s'étend, à l'état monté du capot (20) de blindage, sensiblement parallèlement à la face (4) d'implantation et chaque languette (8) est formée du côté du pourtour extérieur et est en retrait dans le tracé d'une paroi (17) du capot (20) de blindage.

7. Dispositif de blindage suivant au moins l'une des revendications précédentes, **caractérisé en ce que** la pièce (22) d'étanchéité est constituée sous la forme d'une garniture (13) d'étanchéité plate et est fixée par une colle (14) conductrice de l'électricité sur le bord (3) du capot (20) de blindage ou de la face (4) d'implantation.

8. Dispositif de blindage suivant au moins l'une des revendications précédentes, **caractérisé en ce que** le capot (20) de blindage est constitué sous la forme d'une pièce découpée-pliée.

9. Dispositif de blindage suivant au moins l'une des revendications précédentes, **caractérisé en ce que** le capot (20) de blindage est parallélépipédique.

10. Dispositif de blindage suivant au moins l'une des revendications précédentes, **caractérisé en ce qu'**il est prévu sur la partie (16) et/ou sur une partie (17) de paroi du capot (20) de blindage des traversées (15).

11. Dispositif de blindage suivant au moins l'une des revendications précédentes, **caractérisé en ce qu'**il est disposé sur la plaquette (2) à circuit imprimé plusieurs capots (20) de blindage et l'efficacité de blindage de ces capots de blindage est différente.

12. Dispositif de blindage suivant au moins l'une des revendications précédentes, **caractérisé en ce que** la pièce (22) d'étanchéité est en un matériau polymère, notamment de préférence en un non-tissé en polyamide qui est revêtu métalliquement ou qui est tricoté par une toile métallique.

13. Dispositif de blindage suivant au moins l'une des revendications précédentes, **caractérisé en ce que** la pièce (22) d'étanchéité est en un élastomère conducteur de l'électricité qui est guipée par une toile en fils d'acier, plaquée de cuivre et étamée.

## Claims

1. Screening device, comprising:
- a screening cover (20) which covers an electronic circuit disposed on a printed circuit board (2) with an edge (3) which is separated from a component side (4) of the printed circuit board by a gap,
- a contacting device (6) which is disposed in the gap and establishes an electrical connection between the screening cover and a conducting contour (7) on the printed circuit board, wherein lugs (8) are formed on the edge of the screening cover by means of which the screening cover is registered on the printed circuit board and the contacting device is held under elastic pretension, wherein the contacting device is embodied as an elastic sealing element (22) running around the perimeter in the gap and absorbing electromagnetic waves, **characterised in that** the conducting contour (7) is formed by dome-shaped contact points (21).

2. Screening device according to claim 1, **characterised in that** the dome-shaped contact points (21) are disposed on the component side (4) of the printed circuit board (2) at the printed circuit board reference grid pitch.

3. Screening device according to claim 1 or 2, **characterised in that** the printed circuit board (2) is provided with openings (10), that after the screening cover (20) is registered the lugs (8) protrude from the opening on the exit side and plastically deformed end sections (9) of the lugs grip the back of the printed circuit board (2).

4. Screening device according to claim 3, **characterised in that** each end section of a lug (8) is embodied as a hinged flap (11).

5. Screening device according to at least one of the preceding claims, **characterised in that** the screening cover (20) is formed from a uniform material and in one piece, with each element transitioning into another, and is made of a metallic material.

6. Screening device according to at least one of the preceding claims, **characterised in that** the edge (3) is embodied as a right-angled fold (12) which, in the assembled state of the screening cover (20), runs essentially parallel to the component side (4), and that each lug (8) is formed on the outside perimeter and is embodied offset along a wall (17) of the screening cover (20).

7. Screening device according to at least one of the preceding claims, **characterised in that that** the sealing element (22) is embodied as a flat seal (13) and is secured by an electrically conductive adhesive (14) at the edge (3) of the screening cover (20) or the component side (4).

8. Screening device according to at least one of the preceding claims, **characterised in that** the screening cover (20) is embodied as a punched-bent part.

9. Screening device according to at least one of the preceding claims, **characterised in that** the screening cover (20) is embodied in a cuboid or rectangle shape.

10. Screening device according to at least one of the preceding claims, **characterised in that** cutouts (15) are provided on a top part (16) and/or on a side wall (17) of the screening cover (20).

11. Screening device according to at least one of the preceding claims, **characterised in that** a plurality of screening covers (20) are disposed on a printed circuit board (2) and the screening efficiency of these screen covers is different.

12. Screening device according to at least one of the preceding claims, **characterised in that** the sealing element (22) is formed from a polymer material, in particular preferably from a polyamide weave or fleece which is metallically coated or surrounded by a metallic mesh.

13. Screening device according to at least one of the preceding claims, **characterised in that** the sealing element (22) is formed from an electrically conductive elastomer that is braided by a tinned, copper-coated steel wire mesh.
